# FASCICULE DE BREVET EUROPEEN

(11) **EP 3 042 398 B1**
(45) Date de publication et mention de la délivrance du brevet: **30.05.2018**
(21) Numéro de dépôt: 14767142.4
(22) Date de dépôt: 04.09.2014
(51) Int. Cl.: H01L 31/0468

(54) **MODULE PHOTOVOLTAÏQUE SEMI-TRANSPARENT ET PROCÉDÉ D'OBTENTION CORRESPONDANT**
SEMITRANSPARENTES FOTOVOLTAIKMODUL UND ZUGEHÖRIGES HERSTELLUNGSVERFAHREN
SEMITRANSPARENT PHOTOVOLTAIC MODULE AND CORRESPONDING MANUFACTURING PROCESS

(30) Priorité: 05.09.2013 FR 1358509
(43) Date de publication de la demande: 13.07.2016
(73) Titulaire: Commissariat à l'Énergie Atomique et aux Énergies Alternatives, 75015 Paris (FR); Crosslux, 13790 Rousset (FR)
(72) Inventeur: KARST, Nicolas, 57600 Folkling (FR); FAUCHERAND, Pascal, 38360 Sassenage (FR); PERRAUD, Simon, 83150 Bandol (FR); ROUX, Frédéric, 38120 Saint-Egreve (FR); THOULON, Pierre-Yves, 13100 Le Tholonet (FR)
(74) Mandataire: Gevers & Orès
(86) Numéro de dépôt international: PCT/IB2014/064254
(87) Numéro de publication internationale: WO 2015/033291

(56) Documents cités:
- FR-A1- 2 997 226
- FR-A1- 2 997 227
- GB-A- 2 472 608
- US-A- 4 795 500
- US-A1- 2010 126 559
- US-B1- 7 795 067

## Description

L'invention concerne le domaine technique de l'énergie solaire photovoltaïques et plus particulièrement les modules photovoltaïques en couches minces.

Dans le cadre de la présente demande, une « couche mince » sera une couche présentant une épaisseur inférieure à 5µm.

Pour faciliter l'intégration des panneaux photovoltaïques dans les bâtiments et optimiser la surface qu'ils occupent, il est souhaitable de disposer de panneaux photovoltaïques partiellement transparents. En effet, ils peuvent alors remplacer une partie du vitrage du bâtiment dans lequel ils sont intégrés.

Un module photovoltaïque comprend classiquement plusieurs cellules photovoltaïque mises en série.

Une cellule photovoltaïque en couches minces présente la structure d'un empilement comprenant successivement un substrat transparent ou non, une électrode en face arrière (par exemple en métal ou en un oxyde transparent conducteur), une couche de matériau absorbeur (par exemple une couche de CIGS, CZTS, silicium amorphe hydrogéné, silicium microcristallin hydrogéné, tellure de cadmium), et enfin une électrode en face avant (par exemple en métal ou en un oxyde transparent conducteur). Dans le cas notamment d'un absorbeur en CIGS ou CZTS, une couche tampon entre l'absorbeur et l'électrode en face avant peut être utilisée.

Par tailleurs, la mise en série de plusieurs cellules photovoltaïques peut être obtenue par des étapes de gravure et de dépôt réalisées sur un même substrat. Cette interconnexion monolithique des cellules photovoltaïques en couches minces est réalisée en trois étapes, classiquement dénommées P1, P2 et P3,

La première étape (P1) assure l'isolation électrique de deux cellules adjacentes au niveau de l'électrode en face arrière des cellule photovoltaïques.

La deuxième étape (P2) permet de connecter l'électrode en face avant d'une cellule donnée à l'électrode en face arrière de la cellule adjacente.

La troisième étape (P3) consiste à isoler électriquement deux cellules adjacentes au niveau de l'électrode en face avant.

Plusieurs solutions ont déjà été proposées pour réaliser un une cellule photovoitaïque semi-transparente ou un module photovoltaïque semi-transparent.

Ainsi, le document US 2010/0126559 décrit un module photovoltaïque du type superstrat, dans laquelle le substrat et l'électrode en face arrière sont transparents. Par ailleurs, l'ouverture obtenue lors de l'étape de gravure P3 présente une largeur adaptée à la transparence souhaitée pour le modale photovoltaïque final. Cette ouverture est réalisée à travers la couche absorbante et l'électrode de face avant. Cette largeur peut par exemple varier entre 5 et 10% de la largeur d'une cellule photovoltaïque.

De façon générale, le module photovoltaïque obtenu peut transmettre entre environ 5 est 50% de la lumière incidente.

Cette solution présente cependant des inconvénients.

En particulier, les ouvertures réalisées dans le module photovoltaïque sont en forme de ligné, Elles sont alors relativement visibles et ne permettent pas une transmission uniforme de la lumière. En effet, pour que la lumière soit transmise de manière uniforme et que l'ensemble du module apparaisse partiellement transparent, il est nécessaire que les structures laissant passer la lumière soit indiscernables.

Le document GB-2472608 propose de réaliser une cellule photovoltaïque semi-transparente à partir d'un empilement comprenant un substrat et une électrode de face arrière transparents et une couche absorbante et une électrode de face avant opaques.

Des petits trous sont formés à travers l'électrode de face avant et la couche active opaques, de façon à permettre la transmission de lumière à travers ces trous.

Ces trous sont obtenus par des opérations de gravure humide. Ainsi, un liquide de gravure est déposé sur la surface des cellules photovoltaïques par l'intermédiaire d'une tête à jet d'encre, de façon à permettre une gravure localisée d'au moins la première couche de l'empilement.

L'empilement étant constitué de couches de matériaux présentant une nature chimique différente, il est nécessaire d'utiliser successivement différents liquides de gravure pour permettre la formation de trous sur la profondeur souhaitée.

Le procédé décrit dans ce document permet d'éviter la formation de lignes qui sont facilement visibles.

Cependant, l'utilisation de différents liquides de gravure rend ce procédé relativement complexe. Des problèmes de compatibilité entre les matériaux de l'empilement et les liquides de gravure utilisés peuvent également survenir.

Le document US-7795067 décrit des cellules photovoltaïques semi-transparentes qui sont également obtenues à partir d'un empilement de couches dans lequel est réalisée une pluralité de trous.

Contrairement aux cellules décrites dans le document GB-2472608, ces trous traversent complètement l'empilement.

Ils peuvent être réalisés par un moyen mécanique, par exemple par perçage ou découpage.

Ces procédés mécaniques présentent l'inconvénient, comme dans la plupart des procédés engendrant un retrait de matière, d'amener à la formation de courts-circuits localisés, du fait de la présence de résidus de matière au sein des trous ou de la formation de « lambeaux » de matière qui ne se sont pas totalement détachés et qui réalisent un pont électrique (dans le cas d'un matériau conducteur électrique comme le molybdène ou l'oxyde transparent conducteur) entre l'électrode supérieure et l'électrode inférieure par exemple.

Le document US 4 795 500 A décrit un produit intermédiaire pour l'obtention d'un module photovoltaïque comprenant un substrat, un empilement de couches dans lequel est réalisée une pluralité de trous.

Le procédé de fabrication des cellules photovoltaïques ne permet pas le dépôt d'un matériau isolant et transparent dans les trous du produit intermédiaire, de manière à ce que la couche absorbante soit dépourvue de ce matériau. Par conséquent, il ne permet la fabrication d'un produit intermédiaire de manière simplifiée.

De plus, en l'absence du matériau isolant dans les trous du module, le procédé ne permet pas de former une électrode de face avant sur l'ensemble du produit intermédiaire obtenu et ainsi d'améliorer les performances électriques du module photovoltaïque.

L'invention a pour objet de pallier ces inconvénients en proposant un procédé d'obtention d'un module photovoltaïque semi-transparent qui est d'une réalisation simplifiée tout en permettant d'obtenir un module photovoltaïque assurant une transmission uniforme de la lumière et une vision continue, sans risque de courts-circuits.

L'invention concerne également un procédé d'obtention d'un module photovoltaïque comportant une pluralité de cellules photovoltaïques dans une structure en couches minces, comprenant les étapes suivantes :
- une étape de réalisation d'un produit intermédiaire par le dépôt sur l'ensemble d'un substrat d'une couche d'un matériau conducteur, la formation d'une couche absorbante sur cette couche d'un matériau conducteur, et la réalisation de trous à travers l'empilement constitué par la couche d'un matériau conducteur et la couché absorbante, la couche en matériau conducteur formant l'électrode en face arrière,
- une étape de dépôt d'un matériau isolant et transparent dans les trous du produit intermédiaire, la couche absorbante étant dépourvue de ce matériau, et
- une étape de dépôt d'une couche formant l'électrode de face avant sur l'ensemble du produit obtenu.

De préférence, les trous présentent une section dont la surface est comprise entre 0,005 mm² et 0,2 mm² et la surface totale occupée par les trous est comprise entre 5% et 95% de la surface totale du substrat.

Ces trous peuvent être réalisés grâce à un procédé mécanique (notamment perçage) ou chimique (notamment gravure chimique, impliquant éventuellement l'utilisation d'un masque), ou par tout autre procédé.

De façon préférée, l'étape de dépôt d'un matériau isolant et transparent dans les trous du produit intermédiaire comprend les opérations suivantes :
- le dépôt d'une résine sur l'ensemble du substrat pour recouvrir la couche absorbante et remplir les trous du produit intermédiaire,
- la réticulation de la résine présente dans les trous, et
- l'élimination de la résine non réticulée présente sur la couche absorbante,

De façon avantageuse, la résine est une résine photosensible négative qui est tout d'abord soumise à une étape de recuit avant d'être insolée à travers le substrat, la couche en matériau conducteur formant un masque.

En variante, le procédé comprend une étape de dépôt d'une couche tampon avant le dépôt de la couche formant l'électrode de face avant.

Après le dépôt de la couche formant l'électrode de face avant et l'éventuelle couche tampon, la résine réticulée peut être éliminée par l'action d'un solvant.

L'invention concerne également un modale photovoltaïques semi-transparent selon la revendication 8. De préférence, le matériau insolant est une résine transparente réticulée.

Ces zones présentent une section dont la surface est comprise entre 0,005 mm² et 0,2 mm² et représentent environ entre 5% et 95% de la surface totale du substrat,

Le module peut également comprendra une couche tampon entre la couche absorbante et l'électrode de face avant.

Dans un mode de réalisation, la couche tampon est une couche continue.

Enfin, l'électrode de face arrière est réalisée en un matériau métallique, notamment en molybdène, ou en un oxyde transparent conducteur, notamment une oxyde de zinc dopé à l'aluminium, ou en tout autre matériau conducteur. Il est également décrit un produit intermédiaire pour l'obtention d'un module photovoltaïque selon l'invention, constitué, sur un substrat, par un empilement formé d'une couche en matériau conducteur et d'une couche absorbante et qui comporte des trous le traversant.

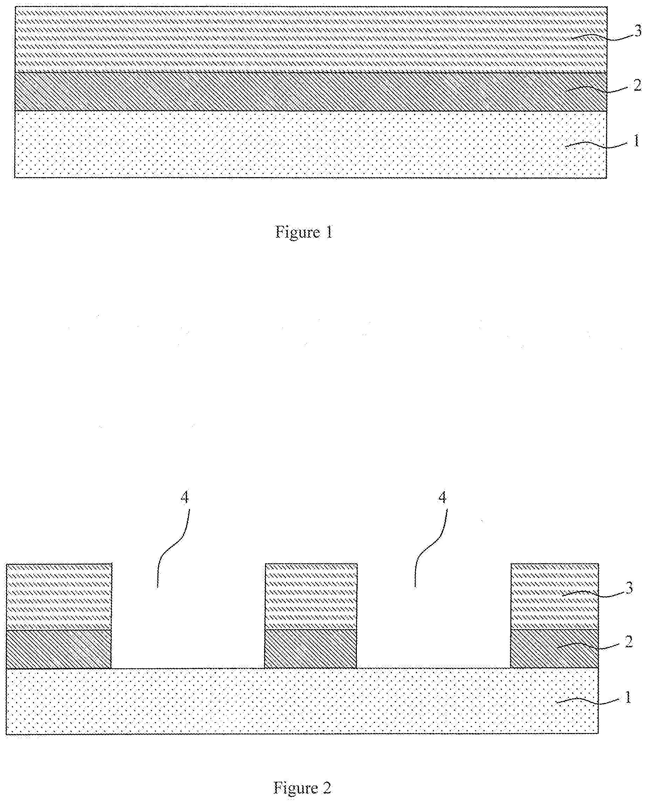

L'invention sera mieux comprise et d'autres buts, avantages et caractéristiques de celle-ci apparaîtront plus clairement à la lecture de la description qui suit et qui est faite au regard des dessins annexés, sur lesquels les figures 1 à 7 représentent différentes étapes de mise en oeuvre du procédé selon l'invention.

Toutes ces figures sont des vues en coupe et les éléments communs aux différentes figures seront désignés par les mêmes référence. Elles n'illustrent pas avec précision l'épaisseur relative des différentes couches représentées.

La figure 1 montre un substrat 1 qui peut être réalisé en divers matériaux transparents, classiquement en verre ou en polymère.

Le substrat 1 peut être souple ou rigide.

En général, ce substrat est réalisé en verre sodocalcique dont l'épaisseur est de quelques millimètres et notamment compense entre 1 et 4 mm.

Sur ce substrat 1, est déposée une couche d'un matériau conducteur 2 formant une électrode de face arrière pour les différentes cellules du module photovoltaïque qui sera obtenu par le procédé selon l'invention,

Cette couche est par exemple réalisée en un matériau métallique et notamment en molybdène et son épaisseur est comprise entre 100 nm et 2 µm et notamment égale à 1 µm.

Le dépôt de la couche de molybdène peut notamment être réalisé par pulvérisation cathodique.

Cette couche 2 peut également être réalisée en un oxyde transparent conducteur, notamment un oxyde de zinc dopé à l'aluminium.

Sur cette couche 2 est formée une couche absorbante 3. Cette couche absorbante peut être une couche de CIGS, CZTS, silicium amorphe hydrogéné, silicium microcristallin hydrogéné, tellure de cadmium. L'épaisseur de cette couche absorbante est typiquement comprise entre 100 nm et 5 µm.

Préférentiellement, cette couche absorbante est une couche mince de CSGS ou de CZTS, d'épaisseur comprise entre 1 µm et 2 µm. Dans ce cas, cette couche absorbante peut être formée par dépôt par co-évaporation à partir de sources élémentaires, ou encore par un procédé séquentiel, comme cela est bien connu dans le domaine des cellules photovoltaïques en couches minces de CIGS ou CZTS.

Dans le cas d'un procédé séquentiel, sur la couche 2, sont apportés, sous la forme d'une couche, les précurseurs qui conduiront à la formation de la couche absorbante en CIGS ou CZTS, Les précurseurs sont préférentiellement des métaux (Cu, In, Ga dans le cas du CIGS; Cu, Zn, Sn dans le cas du CZTS), mais peuvent être également des composés de métaux et de sélénium, ou encore des composés de métaux et de soufre. Une couche mince de sélénium ou de soufre peut être déposée sur la couche de précurseurs.

Ces précurseurs peuvent être apportés par différents procédés de dépôt, Il peut s'agir de procédé sous vide, comme l'évaporation ou la pulvérisation cathodique ou de procédé hors vide, comme le coulage en bande (doctor blading), l'enduction centrifuge (spin coating), la sérigraphie ou l'électrodépôt.

Au moins une étape de recuit est réalisée de façon à convertir les précurseurs en un matériau absorbeur, du type CIGS ou CZTS, grâce à l'apport de sélénium ou de soufre.

La couche 3 est obtenue à l'issue de l'étape de recuit.

La figure 2 illustre une autre étape du procédé dans laquelle des trous 4 sont réalisés dans l'empilement constitué par la couche 2 en matériau conducteur et la couche absorbante 3,

Chaque trou présente une surface comprise entre 0,005 mm² et 0,2 mm² et la surface totale occupée par les trous est comprise entre 5 % et 95 % de la surface totale du substrat.

Ainsi, ces trous sont suffisamment petits pour être invisibles par un oeil humain, à une distance du panneau de l'ordre de quelques dizaines de centimètres.

Ces trous 4 peuvent être réalisés par des procédés connus, tels que ceux décrits dans le document US-7 795 067 ou G8-2472608, Ces trous peuvent être réalisés par tout autre type de procédé.

Les trous 4 peuvent également être réalisés par une méthode utilisant un masque.

Ce masque peut être déposé sur le substrat 2 avant le dépôt des couches 2 et 3 et forme alors un pochoir en positif des trous 4. Après le dépôt des couches 2 et 3, le masque est retiré, notamment par gravure chimique, entraînant avec lui la partie des couches minces dont il est recouvert, celles déposées directement sur le substrat restant en place,

La figure 2 montre que ces trous ne sont pas traversants. En d'autres termes, ils ne passent pas à travers le substrat qui reste continu après la formation des trous,

Le produit illustré à la figure 2 constitue un produit intermédiaire qui peut être réalisé indépendamment des étapes du procédé qui sont mises en oeuvre ultérieurement

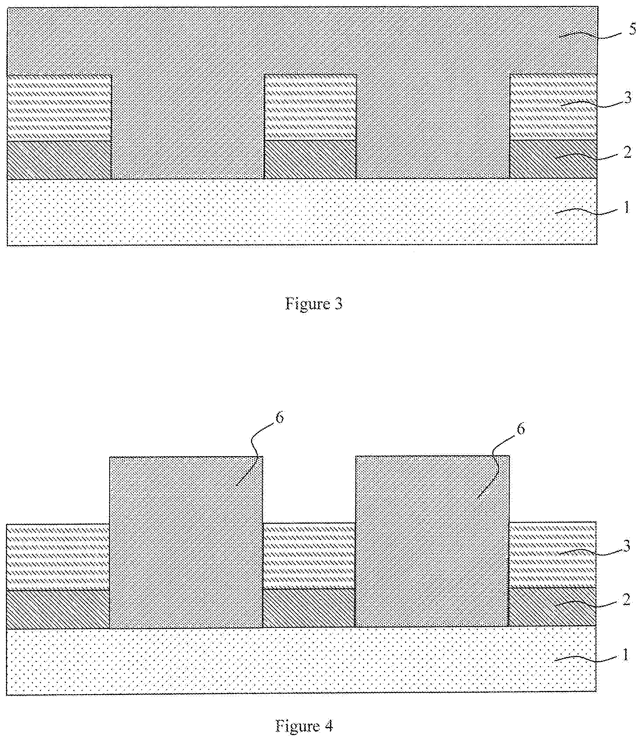

Les figures 3 à 7 illustrent les autres étapes du procédé qui permettent d'obtenir un module photovoltaïque semi-transparent.

En référence à la figure 3, une couche de résine 5 est déposée sur l'ensemble du substrat de façon à remplir les trous 4 et recouvrir la couche absorbante 3.

Dans l'exemple illustré, la résine utilisée est une résine photosensible négative, c'est-à-dire une résine photosensible pour laquelle la partie exposée à la lumière devient insoluble au révélateur et où la partie non exposée à la lumière reste soluble,

Une résine de ce type est principalement composée de trois composants : une résine époxy, un solvant organique permettant de solubiliser la résine et d'ajuster la viscosité de la formulation et un photo-amorceur permettant d'amorcer la polymérisation cationique.

De telles résines sont notamment décrites dans la thèse de Fend Shi « Etudes et propriétés physico-chimie de surfaces microstructurées » (Institut National Polytechnique de Touloupe, - 2006),

A titre d'exemple, pourra être utilisée la résine commercialisée par la société Microchem sous la dénomination SU-8.

Cette couche 5 pourra être par exemple déposée par enduction centrifuge ou par coulage en bande,

Son épaisseur depuis le substrat 1 sera typiquement comprise entre 1 µm et 100 µm.

De préférence, l'épaisseur de la couche 5 sera supérieure à l'épaisseur de l'empilement constitué par la couche 2 et la couche 3, comme cela est illustré à la figure 3. Cependant, dans le cadre de l'invention, il suffit que l'épaisseur de la couche 5 soit supérieure à celle de la couche 2.

Après le dépôt de cette couche 5, une étape de recuit à basse température est réalisée.

La température du recuit est comprise entre 25 et 150°C et, de préférence, égale à 90°C.

La durée de cette étape de recuit est comprise entre 1 et 60 mn et de préférence, égale à 30 min.

Une fois cette étape de recuit réalisée, la résine est ensuite insolée au travers du substrat 1, grâce à une lampe dont la langueur d'onde est comprise entre 350 et 400 nm et, de préférence, à 365 nm.

La couche 2 est opaque, elle sert de masque et empêche donc la lumière d'atteindre la résine présente sur la couche 3.

En pratique, la couche 3 est également opaque puisqu'elle absorbe le rayonnement lumineux.

Ainsi, seule la résine présente dans les trous 4 sera réticulée.

La figure 4 illustre une autre étape dans laquelle la résine présente sur la couche absorbante 3 est retirée à l'aide d'un solvant approprie.

Ce retrait est possible puisque la résine présente sur la couche absorbante 3 n'est pas réticulée.

A titre d'exemple, ce solvant pourra être du PGMEA (polypropylène-glycol-métyl-ether-acétate).

La figure 4 illustre l'empilement obtenu après retrait de la résine non réticulée,

Ce produit présente donc des zones 6 constituées de résine qui est un matériau isolant et transparent.

Ces zones 6 sont en saillie par rapport au plan défini par la couche absorbante 3.

La partie des zones 6 située au-dessus de ce plan présente une épaisseur comprise entre 100 nm et 100 µm, suivant l'épaisseur de la couche 5.

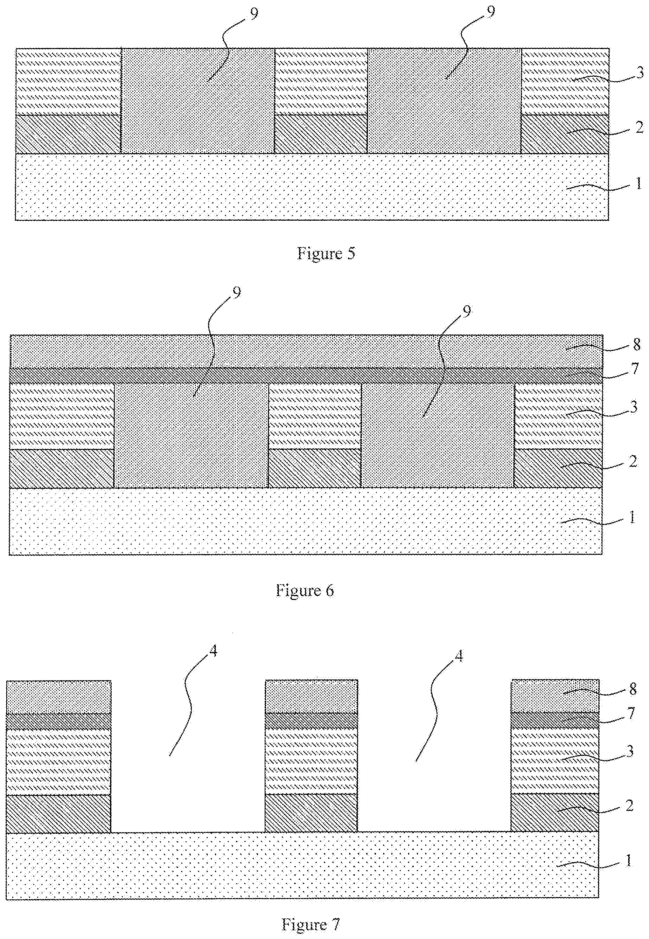

La figure 5 illustre une autre étape du procédé dans laquelle la partie des zones 6 situées au-dessus de la couche absorbante a été éliminée, par exemple par polissage mécanique. Elle permet d'obtenir des zones 9 constituées d'un matériau transparent et isolant qui remplit donc les trous 4, Cette étape est facultative.

La dernière étape du procédé est illustrée à la figure 6.

Elle consiste tout d'abord à déposer une couche tampon, c'est-à-dire une couche composée d'un matériau semi-conducteur de type n.

La couche tampon 7 est une couche très mince dont l'épaisseur est généralement comprise entre 5 nm et 100 nm et qui est réalisée en un matériau semi-conducteur de type n à grande largeur de bande interdite. Il s'agit donc d'une couche présentant un fort taux de transmission optique dans le visible.

Le matériau formant la couche 7 peut être à base de sulfuré de cadmium (CdS), ou de sulfure de zinc (ZnS).

Cette couche tampon peut être déposée notamment par bain chimique, par pulvérisation cathodique ou encore évaporation.

Elle est de préférence à base de sulfure de zinc (ZnS) et présente une épaisseur de préférence comprise entre 5 et 100 nm.

Cette couche tampon 7 est facultative.

Enfin, une électrode transparente 8 est déposée sur la couche tampon 7, ou directement sur la couche absorbante si la couche tampon est omise.

L'électrode 8 est généralement réalisée en un oxyde transparent conducteur et présente un fort taux de transmission optique dans le visite.

Elle est de préférence à base de ZnO dopé à l'aluminium et présente une épaisseur de préférence comprise entre 100 nm et 1 µm.

De façon facultative, une couche d'un matériau transparent peut être déposée entre les couches 7 et 8. Elle est de préférence réalisée en ZnO.

On obtient alors la cellule photovoltaïque illustrée à la figure 6. Grâce à la présence des zones 9 constituées d'un matériau transparent et à une répartition appropriée de ces zones, cette cellule photovoltaïque est semi-transparente.

Les couches 7 et 8 sont continues et planes, puisque les zones 9 sont au même niveau que la surface de la couche 3.

Par ailleurs, la présence d'un matériau isolant dans les trous 4 permet d'éviter que, après formation des trous, la couche 7 ou la couche 8 vienne en contact avec l'électrode 2 en face arrière. Ceci permet d'éviter tout court-circuit entre la couche 7 ou la couche 8 et l'électrode 2 en face arrière, de tels courts-circuits dégradant fortement les performances du module photovoltaïque.

Pour réaliser un module photovoltaïques (non illustré), faut réaliser des étapes de gravure pour assurer l'interconnexion monolithique des différentes cellules solaires formées sur le substrat. Par souci de simplification, ces étapes ne sont pas illustrées sur les différentes figures.

En pratique, l'étape de gravure P1 intervient après le dépôt de la couche 2, l'étape P2 après le dépôt de la couche 3 et de la couche 7 et enfin, l'étape P3 après le dépôt de la couche 8.

Dans la mesure où la résine utilisée dans le cadre du procédé sein l'invention est très transparente, en assurant une transmission de la lumière, notamment supérieure à 90%, celle-ci peut être maintenue dans le module photovoltaïques, tout en permettant une excellente transmission de la lumière.

Cependant, il peut être envisagé de retirer la résine présente dans les trous 4, pour augmenter le taux de transmission optique.

Ce retrait de la résine interviendra après le dépôt des couches 7 et 8.

Ce retrait de la résine réticulée sera réalisés au moyen d'un solvant comme du NMP (N-Métyl-2-Pyrrolidinone).

Il convient au préalable de ménager un accès du solvant vers les zones 9 constituées de résine.

Pour cela, il est préférable, avant le dépôt des couches 7 et 8, de ne pas avoir retiré l'excédent de résine situé dans le prolongement des trous au-dessus du niveau la couche absorbante 3, c'est-à-dire de s'être placé dans le cas illustré à la figure 4. En effet, dans ce cas, l'excédent de résine entraîne une rupture localisée des couches 7 et 8 lors du dépôt de celles-ci, ce qui permet au solvant d'atteindre la résine.

Le retrait de la résine réticulée présente dans les trous 4 entraîne également le lift-off des couches 7 et 8 situées dans le prolongement des trous.

L'empilement obtenu est illustré à la figure 7. Ainsi, les trous 4 sont pratiqués dans l'ensemble de l'empilement et non seulement dans les couches 2 et 3. L'empilement illustré à la figure 7 constitue un exemple comparatif de cellule photovoltaïques, ne faisant pas partie de l'invention. Une fois la résine retirée, les zones 9 sont des zones vides ou encore dépourvues de tout matériau, l'air présent constituant un isolant

Les signes de référence insérés après les caractéristiques techniques figurant dans les revendications ont pour seul but de faciliter la compréhension de ces dernières et ne sauraient en limiter la portée.

## Revendications

1. Procédé d'obtention d'un module photovoltaïque comportant une pluralité de cellules photovoltaïques dans une structure en couches minces, comprenant les étapes suivantes :
- une étape de réalisation d'un produit intermédiaire par le dépôt sur l'ensemble d'un substrat (1) d'une couche d'un matériau conducteur (2), la formation d'une couche absorbante (3) sur cette couche d'un matériau conducteur (2), et la réalisation de trous (4) à travers l'empilement constitué par la couche (2) d'un matériau conducteur et la couche absorbante (3), la couche (2) en matériau conducteur formant l'électrode en face arrière,
- une étape de dépôt d'un matériau (5) isolant et transparent dans les trous (4) du produit intermédiaire, la couche absorbante (3) étant dépourvue de ce matériau, et
- une étape de dépôt d'une couche (8) formant l'électrode de face avant, sur l'ensemble du produit obtenu.

2. Procédé selon la revendication 1, dans lequel, lors de l'étape de réalisation d'un produit intermédiaire, les trous réalisés présentent une section dont la surface est comprise entre 0,005 mm² et 0,2 mm², la surface totale occupée par les trous étant comprise entre 5% et 95% de la surface totale du substrat.

3. Procédé selon la revendication 1 ou 2, dans lequel les trous sont réalisés par un procédé mécanique ou chimique, notamment par gravure chimique, impliquant éventuellement un masque.

4. Procédé selon l'une des revendications 1 à 3, dans lequel l'étape de dépôt d'un matériau isolant et transparent dans les trous (4) du produit intermédiaire comprend les opérations suivantes :
- le dépôt d'une résine sur l'ensemble du substrat pour recouvrir la couche absorbante (3) et remplir les trous (4) du produit intermédiaire,
- la réticulation de la résine présente dans les trous (4), et
- l'élimination de la résine non réticulée présente sur la couche absorbante (3).

5. Procédé selon la revendication 4, dans lequel la résine est une résine photosensible négative qui est soumise à une étape de recuit avant d'être insolée à travers le substrat, la couche (2) formant un masque.

6. Procédé selon l'une des revendications 1 à 5, comprenant une étape de dépôt d'une couche tampon (7) avant le dépôt de la couche (8) formant l'électrode de face avant.

7. Procédé selon l'une des revendications 4 à 6, dans lequel après le dépôt de la couche (8) formant l'électrode de face avant et de l'éventuelle couche tampon (7), la résine réticulée est éliminée par l'action d'un solvant.

8. Module photovoltaïque semi-transparent comprenant une pluralité de cellules photovoltaïques connectées en série sur un substrat commun (1) et comprenant une électrode de face avant (8) et une électrode de face arrière (2), en contact avec ledit substrat et espacée de l'électrode de face avant (8) par au moins une couche absorbante (3), dans lequel l'empilement constitué par l'électrode de face arrière (2) et la couche absorbante (3) comprend des zones (9) constituées d'un matériau isolant et transparent, **caractérisé en ce que** l'électrode de face avant forme une couche continue sur chacune desdites cellules photovoltaïques, l'électrode de face avant étant déposée sur la couche absorbante et sur les zones constituées du matériau isolant et transparent.

9. Module selon la revendication 8, dans lequel le matériau isolant est une résine transparente réticulée.

10. Module selon la revendication 8 ou 9, dans lequel ces zones (9) présentent une section dont la surface est comprise entre 0,005 mm² et 0,2 mm² et représente environ 5% à 95% de la surface du substrat.

11. Module selon l'une des revendications 8 à 10, comprenant une couche tampon (7) entre la couche absorbante (3) et l'électrode de face avant (8).

12. Module selon la revendication 11, dans lequel la couche tampon est une couche continue.

13. Module selon l'une des revendications 8 à 12, dans lequel l'électrode de face arrière (2) est réalisée en un matériau métallique, notamment en molybdène, ou en un oxydant transparent conducteur, notamment un oxyde de zinc dopé à l'aluminium.

## Patentansprüche

1. Verfahren zum Erhalt eines Photovoltaikmoduls, aufweisend eine Vielzahl photovoltaischer Zellen in einer Dünnschichtstruktur, welches die folgenden Schritte umfasst:
- einen Schritt des Herstellens eines Übergangsprodukts durch das Aufbringen auf die Gesamtheit eines Substrats (1) einer Schicht eines leitenden Materials (2), das Bilden einer absorbierenden Schicht (3) auf dieser Schicht eines leitenden Materials (2) und das Herstellen von Löchern (4) durch den Stapel, gebildet durch die Schicht (2) eines leitenden Materials und die absorbierende Schicht (3), wobei die Schicht (2) aus leitendem Material die Elektrode auf der Rückseite bildet,
- einen Schritt des Aufbringens eines isolierenden und transparenten Materials (5) in den Löchern (4) des Übergangsprodukts, wobei die absorbierende Schicht (3) von diesem Material ausgespart ist, und
- einen Schritt des Aufbringens einer Schicht (8), welche die Vorderseitenelektrode bildet, auf die Gesamtheit des erhaltenen Produkts.

2. Verfahren nach Anspruch 1, wobei bei dem Schritt des Herstellens eines Übergangsprodukts die hergestellten Löcher einen Querschnitt aufweisen, dessen Oberfläche zwischen 0,005 mm² und 0,2 mm² beträgt, wobei die von den Löchern belegte Gesamtfläche zwischen 5 % und 95 % der Gesamtfläche des Substrats beträgt.

3. Verfahren nach Anspruch 1 oder 2, wobei die Löcher mittels eines mechanischen oder chemischen Verfahrens, insbesondere durch chemisches Ätzen, hergestellt sind, das eventuell eine Maske impliziert.

4. Verfahren nach einem der Ansprüche 1 bis 3, wobei der Schritt des Aufbringens eines isolierenden und transparenten Materials in den Löchern (4) des Übergangsprodukts die folgenden Vorgänge umfasst:
- das Aufbringen eines Harzes auf die Gesamtheit des Substrats, um die absorbierende Schicht (3) zu bedecken und um die Löcher (4) mit Übergangsprodukt zu füllen,
- das Vernetzen des in den Löchern (4) vorhandenen Harzes, und
- das Entfernen des nicht vernetzten Harzes, das auf der absorbierenden Schicht (3) vorhanden ist.

5. Verfahren nach Anspruch 4, wobei das Harz ein negatives photosensibles Harz ist, das einem Temperschritt unterzogen wird, bevor es durch das Substrat isoliert wird, wobei die Schicht (2) eine Maske bildet.

6. Verfahren nach einem der Ansprüche 1 bis 5, umfassend einen Schritt des Aufbringens einer Pufferschicht (7) vor dem Aufbringen der Schicht (8), welche die Vorderseitenelektrode bildet.

7. Verfahren nach einem der Ansprüche 4 bis 6, wobei, nach dem Aufbringen der Schicht (8), welche die Vorderseitenelektrode bildet, und der eventuellen Pufferschicht (7) das vernetzte Harz durch die Wirkung eines Lösungsmittels entfernt wird.

8. Semitransparentes Photovoltaikmodul, umfassend eine Vielzahl photovoltaischer Zellen, die in Reihe auf einem gemeinsamen Substrat (1) geschaltet sind und eine Vorderseitenelektrode (8) und eine Rückseitenelektrode (2) im Kontakt mit dem Substrat und beabstandet von der Vorderseitenelektrode (8) durch mindestens eine absorbierende Schicht (3) umfassen, wobei der Stapel, der von der Rückseitenelektrode (2) und der absorbierenden Schicht (3) gebildet ist, Zonen (9) umfasst, die von einem isolierenden und transparenten Material gebildet sind, **dadurch gekennzeichnet, dass** die Vorderseitenelektrode eine kontinuierliche Schicht auf jeder der photovoltaischen Zellen bildet, wobei die Vorderseitenelektrode auf der absorbierenden Schicht und auf den Zonen, die von dem isolierenden und transparenten Material gebildet sind, aufgebracht ist.

9. Modul nach Anspruch 8, wobei das isolierende Material ein vernetztes transparentes Harz ist.

10. Modul nach Anspruch 8 oder 9, wobei diese Zonen (9) einen Querschnitt aufweisen, dessen Oberfläche zwischen 0,005 mm² und 0,2 mm² beträgt und zirka 5 % bis 95 % der Oberfläche des Substrats darstellt.

11. Modul nach einem der Ansprüche 8 bis 10, umfassend eine Pufferschicht (7) zwischen der absorbierenden Schicht (3) und der Vorderseitenelektrode (8).

12. Modul nach Anspruch 11, wobei die Pufferschicht eine kontinuierliche Schicht ist.

13. Modul nach einem der Ansprüche 8 bis 12, wobei die Rückseitenelektrode (2) aus einem metallischen Material, insbesondere aus Molybdän, oder aus einem leitenden transparenten Oxidans, insbesondere einem mit Aluminium dotierten Zinkoxid, hergestellt ist.

## Claims

1. Method for obtaining a photovoltaic module comprising a plurality of photovoltaic cells in a thin-film structure, comprising the following steps:
- a step of implementing an intermediate product by the deposition, on the entirety of a substrate (1), of a layer of a conductive material (2), the formation of an absorbing layer (3) on this layer of a conductive material (2), and the implementation of holes (4) through the stack formed by the layer (2) of a conductive material and the absorbing layer (3), the layer (2) of conductive material forming the rear-face electrode,
- a step of depositing an insulating and transparent material (5) in the holes (4) of the intermediate product, the absorbing layer (3) being deprived of this material, and
- a step of depositing a layer (8) forming the electrode on the front face, on the entirety of obtained product.

2. Method according to claim 1, in which, in the step of implementing an intermediate product, the implemented holes have a section of which the surface area ranges between 0.005mm² and 0.2mm², the total surface area occupied by the holes ranging from 5% to 95% of the total surface area of the substrate.

3. Method according to claim 1 or 2, in which the holes are implemented by means of a mechanical or chemical method, in particular by chemical etching, possibly involving a mask.

4. Method according to one of claims 1 to 3, in which the step of depositing an insulating and transparent material in the holes (4) of the intermediate product comprises the following operations:
- the deposition of a resin on the entirety of the substrate to cover the absorbing layer (3) and fill the holes (4) of the intermediate product,
- the crosslinking of the resin present in the holes (4), and
- the elimination of the non-crosslinked resin present on the absorbing layer (3).

5. Method according to claim 4, in which the resin is a negative photosensitive resin which is subjected to an annealing step before being exposed through the substrate, the layer (2) forming a mask.

6. Method according to one of claims 1 to 5, comprising a step of depositing a buffer layer (7) before the deposition of the layer (8) forming the front-face electrode.

7. Method according to one of claims 4 to 6, in which the crosslinked resin is removed by the action of a solvent, after the deposition of the layer (8) forming the front-face electrode and of the possible buffer layer (7).

8. Semi-transparent photovoltaic module comprising a plurality of photovoltaic cells connected in series on a common substrate (1) and comprising a front-face electrode (8) and a rear-face electrode (2), in contact with said substrate and spaced apart from the front-face electrode (8) by at least one absorbing layer (3), in which the stack formed by the rear-face electrode (2) and the absorbing layer (3) comprises zones (9) composed of an insulating and transparent material, **characterised in that** the front-face electrode forms a continuous layer on each of said photovoltaic cells, the front-face electrode being deposited on the absorbing layer and on the zones composed of the insulating and transparent material.

9. Module according to claim 8, in which the insulating material is a transparent crosslinked resin.

10. Module according to claim 8 or 9, in which these zones (9) have a section of which the surface area ranges between 0.005m² and 0.2m² and represents approximately 5% to 95% of the surface area of the substrate.

11. Module according to one of claims 8 to 10, comprising a buffer layer (7) between the absorbing layer (3) and the front-face electrode (8).

12. Module according to claim 11, in that the buffer layer is a continuous layer.

13. Module according to one of claims 8 to 12, in which the rear-face electrode (2) is made of a metallic material, in particular molybdenum, or of a conductive transparent oxide, in particular an aluminium-doped zinc oxide.
